Europäisches Patentamt

(19) European Patent Office

Office européen des brevets

(11) Publication number: **0 230 652
B1**

(12) EUROPEAN PATENT SPECIFICATION

(45) Date of publication of the patent specification:
27.06.90

(21) Application number: 86118001.6

(22) Date of filing: 23.12.86

(51) Int. Cl.⁵: **C23C 14/24,** C23C 14/28
// H05K1/00

(54) Apparatus for creating a vacuum deposited alloy or composition and application of such an apparatus.

(30) Priority: 30.12.85 US 814813

(43) Date of publication of application:
05.08.87 Bulletin 87/32

(45) Publication of the grant of the patent:
27.06.90 Bulletin 90/26

(84) Designated Contracting States:
DE FR GB IT

(56) References cited:
WO-A-85/02866
DD-A- 221 475
GB-A- 2 144 914

PATENT ABSTRACTS OF JAPAN, unexamined
applications, C field, vol. 10, no. 63, March 13, 1986

(73) Proprietor: International Business Machines
Corporation, Old Orchard Road, Armonk, N.Y. 10504(US)

(72) Inventor: Blackwell, Kim Joseph, 4 Water Street, Owego,
N.Y. 13 827(US)
Inventor: White, Russell Thomas, Jr., R.D., Conklin,
N.Y. 13 748(US)

(74) Representative: Mönig, Anton, Dipl.-Ing., IBM
Deutschland GmbH Patentwesen und Urheberrecht
Schönaicher Strasse 220, D-7030 Böblingen(DE)

## Description

The present invention relates to apparatus for creating alloys, and in particular to apparatus for creating alloys by sputtering.

In the manufacture of many electronic components, such as integrated circuits, there is a need to deposit metallic films on substrates. Materials that include copper in particular are often deposited on organic or inorganic substrates and then etched or otherwise fabricated into the circuits and/or components.

It is often desirable to use materials that combine particular physical and electrical characteristics. The resulting composition or − in the case of two or more metals − alloy ultimately benefits the electronic system of which it forms a part. There is often a need, therefore, to mix materials in order to obtain the best properties or qualities of each.

For example, although copper is known to be an excellent electrical conductor, its reputation for strength and adhesion is not as renowned. In manufacturing an electrical circuit, a mixture of copper and chromium would promote adhesion of a circuit line to a substrate while not sacrificing electrical conductive properties.

Titanium nitride is known to have exceptional hardness characteristics, but its electrical conductive properties are relatively inferior. Accordingly, combining titanium nitride with a more conductive material, such as gold or copper, results in a relatively hard material possessing relatively high electrical conductivity.

In forming a mixture of two or more materials from which an electrical circuit can be fabricated, a sputtering process in accordance with the present invention is hereinbelow described.

In the field of plasma deposition, an atom may be displaced from the surface of a target connected to a cathode by a process called sputtering or sputter deposition. In this process, the target may be constructed of copper or of another material. The cathode to which the target is attached is subjected to a high voltage in an inert atmosphere such as argon. The inert gas is ionized, forming a plasma from which positive ions escape to bombard the exposed surface of the target and to dislodge by momentum transfer the atoms or clusters of atoms of the target material. It is this dislodging of the target atoms that is known as sputtering. By repeating this process, a number of these primarily neutral atoms move through the space in front of the target, in a relatively high vacuum, until they strike and condense on the surface of a receiver, known as a sample or substrate, which is generally in close proximity to the target. A coating of atomic or molecular layers of target material can thus be built up on the substrate. The coating, which is generally less than 10 m, is called a thin film. It is generally sufficient for the metallization of integrated circuits.

The most commonly used plasma reactors have one target oriented such that the surface of the target is plane parallel to the surface of the sample on which sputtered atoms are to be deposited. Atoms emitted from the target are distributed according to a cosine law. That is, the number of atoms ejected from the surface of the target is proportional to the cosine of the angle relative to the perpendicular at which they are ejected.

Accordingly, atoms ejected from the target perpendicularly and received at the sample surface perpendicularly provide optimum atom deposition thereof.

Although plasma reactors containing a single target structure are most commonly used, the use of configurations allowing for two target electrodes in one plasma reactor are known in the art. For example, United States patent 4,424,101 issued to Nowicki discloses a method of depositing doped silicides using co-sputtering techniques. In this system, two target electrodes are disposed in a chamber opposite to one or more wafers or other workpieces on which layers of material are to be deposited. Each target is made of a separate and distinct material, one of them being doped silicon, to facilitate electrical conductance. Silicon in its pure state is not an electrical conductor. The wafers or workpieces are disposed on a rotatable platform beneath the targets and are caused to rotate sequentially thereunder. Thus, the first layer deposited on each workpiece is formed of the material of the first target. As the workpiece is caused to move under the second target, a layer of material of the second target is built upon it. The material that consequently accumulates on the workpiece has two or more layers of alternating or interleaved material. The resulting material is not homogeneous or uniform and therefore has limited value as an alloy or mixture in the common sense of the words.

United States patent 4,415,427 issued to Hidler et al discloses a co-sputtering cathode technique for depositing doped thin films on substrates. A relatively large planar magnetron sputtering apparatus with a rectangular sputter erosion region has a vacant center provided for a diode target for sputtering of a dopant. The rectangular portion is used as a magnetically enhanced or magnetron sputtering apparatus which sputters host material. A substrate is provided adjacent to the magnetron/diode apparatus and is moved relative thereto. Material from the magnetron is first deposited on the substrate. As the substrate is moved relative to the magnetron the doped material is deposited onto the layer of host material, once again resulting in interleaving discrete layers of material (i.e., layering) on the substrate.

United States Patent 4 488 956 issued to Scherer et al discloses a cathode system for producing multilayers. The cathode system has one cathode on which two target materials are alternately disposed. Once again, a transport system moves the substrates relative to the cathode. The material deposited on the substrate comprises alternating layers of the two materials of which the target is composed.

In Wo 85/02 866 a sputter deposition apparatus is described comprising a plurality of sputter sources arranged in such a way that their major axes of emission interact at a common point and a substrate being located at or adjacent the common point. The sources can consist of different materials and are energized simultaneously or in turn.

It is an object of the invention to provide an apparatus capable of forming mixtures or alloys that are substantially homogeneous or uniform throughout the thickness of the deposited material.

It is another object of the invention to provide an apparatus with target cathodes of two or more substantially pure materials that could be co-deposited onto a substrate.

These objects are achieved by apparatus as disclosed in claims 1, 8 and 11 and by an application as disclosed in claim 12.

The shield dividing the areas surrounding the targets prevents material from one target from interacting with or being deposited on another target.

In an advantageous embodiment of the inventive apparatus a shielding mechanism is provided by which materials sputtered from one or more targets could be directed to the surface in varying amounts.

Advantageously the apparatus according to the invention can be applied for creating an alloy need not be uniform and in which a layer of initially pure material could blend into an alloy that includes the initial material at predetermined locations.

Other advantageous embodiments of the inventive apparatus are disclosed in the subclaims.

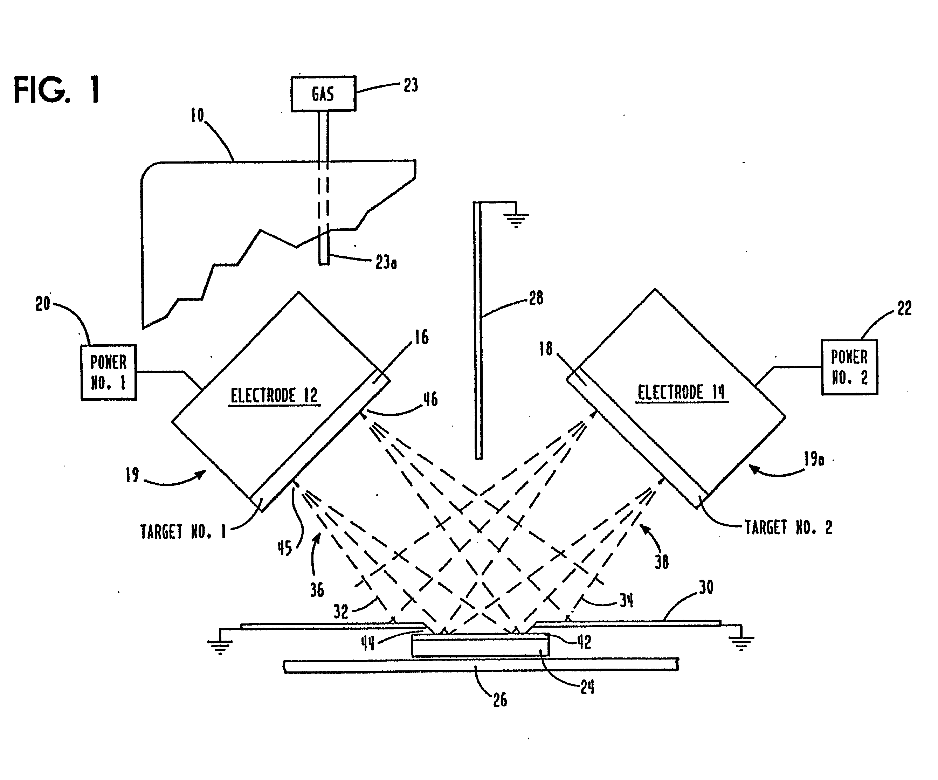

A complete understanding of the present invention may be obtained by reference to the accompanying drawing when taken in conjunction with the detailed description thereof and in which Figure 1 is a cross sectional plan view of the apparatus in accordance with the present invention.

With reference to Figure 1, there is shown a sectional view of the preferred apparatus of the present invention.

A plasma reactor or sputtering chamber 10, such as a conventional chamber for use with vacuums, is provided. Conventional means are provided, not shown, for creating a vacuum in the sputtering chamber 10. Disposed in the chamber 10 are electrodes 12 and 14. The electrodes 12 and 14 can be suitably mounted to the interior of the chamber 10 with hardware internal to the chamber by conventional means, not shown, or can be mounted with hardware external to the chamber 10. Mounting hardware external to the chamber 10 facilitates adjustment and maintenance of the apparatus.

Connected to electrode 12 is a first target 16. The target 16 can be connected to the electrode 12 mechanically or, preferably, by bonding, such as with a solder glue. Similarly, the second target 18 is attached to the second electrode 14.

The material that forms the targets 16 and 18 can be the same, but for purposes of this invention, they should be different from one another. For example, the first target 16 may be formed from any one of the following materials: chromium, copper, palladium, nickel, ceramic, gold and silver. Either electrical insulators or electrical conductors can be used as target materials. Likewise, semiconductor material, such as doped silicon dioxide or gallium arsenide can be used. Even an alloy may be used as a target material, such alloy being composed of two or more elements.

The material in the second target 18 can also be chosen from the aforementioned list of materials. Thus it is possible, and may be preferable for certain applications, to incorporate a first target 16 of chromium and a second target 18 of copper in order to form a film of chromium-copper alloy. In an alternate embodiment, either or both targets 16 and 18 may have two or more materials, all of which being deposited onto the substrate 24 by a common electrode and power supply combination. These two or more materials must be focused, however, as hereinbelow described, in order for proper operation.

The electrode-target component 12, 16 is referred to generally as a target assembly 19. Similarly, components 14 and 18 form a second target assembly 19a. In alternative embodiments, more than two target assemblies, not shown, can be introduced in the chamber 10. In such cases, three or more materials can be combined into an alloy when electrodes are appropriately energized. The specific configuration of the target assemblies is a matter of design based on the objectives of the operator.

Target assembly 19 forms a cathode in an apparatus powered by a direct current (DC) power supply. In an apparatus powered by an alternating current (AC) power supply, however, target assembly 19 would simply be called an electrode. Conductive material can be sputtered both in AC or DC sputtering systems, but nonconductive material can be sputtered only in an AC system.

It should be understood that target assembly 19 can include magnets, not shown, in which case the component is called a magnetron. Such a magnetron having suitable characteristics is available from Leybold-Heraeus Technology Inc. as Model Number PK-500.

Connected to target assembly 19 is a first power supply 20. The power supply 20 can be DC or AC. If the power supply 20 is DC, a relatively high negative voltage is produced for creating a glow discharge or plasma in the space in front of the target 16. Such a DC power supply 20 generates electrons that are eventually emitted from the target 16 through the plasma, as hereinbelow described. A suitable DC power supply can be obtained from Leybold-Heraeus Technology, Inc. as Model Number SSV-15.

Alternatively, the power supply 20 can be one that generates alternating current. When that is the case, an impedance matching network, not shown, may be required to operate the system beyond a certain frequency. It should be understood, however, that the present invention can be implemented at lower AC frequencies. A suitable AC power supply 20 is available, for example, from RF Plasma Products. Connected to second target assembly 19a is a second power supply 22 which has the same characteristics as the first power supply 20. The characteristics of both power supplies 20 and 22 need not be identical, however, for purposes of this invention. Thus, it is entirely conceivable that the first power supply 20 might be a DC device while the second power supply 22 might be an AC device.

A source of inert gas 23, such as argon, is provided so that gas, not shown, can be introduced by means of a tube or pipe 23a into the chamber 10 during operation of the system. The inert gas is ionized by the electrons emitted from the first target 16 and second target 18, thus forming plasma.

It should be understood that gases other than inert gases are suitable for use in a system such as this. In fact, such gases may be used to form the resulting composition of the deposited film. When this objective is sought, a reactive gas (e.g., oxygen) is introduced through the tube 23a into the chamber 10. Two different target materials, such as chromium and copper, may be used to create a copper-chromium oxide or an alloy of chromium oxide and copper oxide.

Oppositely disposed to the target assemblies 19 and 19a is a substrate 24. The substrate 24 can be made of a relatively firm layer of glass epoxy, for example, to be used as an nonconducting carrier of an electrical circuit, not shown. Alternatively, especially for purposes of continuous processing, the substrate 24 can be flexible for ease of handling after alloy deposition. Similarly, the substrate 24 can be formed either of an organic (e.g., polyimide) or an inorganic material and, in fact, can be conductive.

In the preferred embodiment of this invention, the substrate 24 is disposed on a carrier 26, adapted to move by suitable and conventional means, not shown. The substrate 24 is thus permitted to move relative to the target assemblies 19 and 19a. The speed of substrate travel can be adjusted as required and is dependent upon the desired characteristics of resulting deposited material. Moreover, the substrate 24 can be moved in any direction relative to the target assemblies 19 and 19a, including the X, Y or Z direction or combinations thereof.

A shield 28 is provided perpendicular to the substrate 24 to divide the area surrounding the first target assembly 19 from the area surrounding the second target assembly 19a. The shield 28 can be fabricated from stainless steel or copper and should be electrically grounded. The shield 28 separates material emitted from one target (e.g., target 16) from material emitted from the other target (e.g. target 18) and prevents material from one target from interacting with or being deposited on the other target.

A second shield 30 is disposed generally parallel to the substrate 24. This shield 30, also of stainless steel or copper and also grounded, isolates portions of the substrate 24 and prevents predetermined substrate areas from receiving concentrated material from one or the other target 16 and 18. If the substrate 24 is relatively small in comparison to the size of the targets 16 and 18, then the shielding 30 would not be necessary, since a uniform alloy could then be formed over the entire substrate 24. But the configuration and relative sizes of target assemblies 19 and 19a and substrate 24 shown in FIGURE 1 necessitate the shield 30 to ensure uniform and homogeneous alloy deposition onto the substrate 24.

It should be understood that a cooling system, not shown, such as water cooling, can be used in conjunction with the shield 30 in order to reduce the temperature of the substrate 24 while processing thereof. Moreover, means for generating a positive electrical bias, not shown, may also be provided to positively bias the shield 30 in order to trap electrons during processing.

The configuration of the shield 30 should be suitable for the particular purpose of the operator. In a continuous process, for example, the shield 30 would allow an area of the substrate to be coated by an alloy, if required, while allowing a more concentrated amount of a particular target material to be deposited onto another portion (e.g., the edge) of the substrate 24. Such a system would be useful, for example, when the characteristics of the deposited material must vary from the center of the substrate 24 to the edges thereof.

Alternatively, the shield 30 may be configured to allow an initial film of one composition to be deposited first, such composition being different than that of the rest of the deposited film. For example, the initial deposited composition may be a strict alloy, but as the substrate 24 is moved by its carrier 26, the composition of deposited material becomes more concentrated in one target material. Thus, an initial layer of highly adhesive alloy, for example, could be formed directly in contact with the substrate 24, while the adhesive alloy could blend gradually into a different composition that would form the bulk of the deposited material.

In operation, the first and second power supplies 20 and 22 provide electrons to the target assemblies 19 and 19a. Electrons from the targets 16 and 18 accumulate on and are emitted from the surface thereof. The emitted electrons collide with and ionize the argon atoms that are present in the vacuum chamber 10. The resulting argon ions, being positively charged, are then attracted to the negatively charged target surfaces 16 and 18 with such force that they cause ejection (sputtering) of atoms shown generally at reference numerals 32 and 34 from the targets 16 and 18, respectively. The ionization process produces a glow discharge or plasma in the area shown generally at reference numerals 36 and 38.

When the target atoms 32 and 34 condense onto the surface of the substrate 24 substantially simultaneously, an alloy is created. The alloy forms a thin film 42 on the substrate 24.

With low temperature, low pressure sputtering processes, the emission of atoms 32 and 34 from the targets 16 and 18 occurs primarily in a line of sight manner. That is, atoms 32 move from a target 16 to the substrate 24 generally without colliding with one another or with atoms of the sputter gas. When a shield 30 is placed between the line of sight atom source (target 16) and the substrate 24, no atoms from the target 16 are deposited in the area shaded by the shield 30. The shaded area is depicted at reference numeral 44. Thus, if the shielding is configured in such a way as to allow material from the first and second targets 16 and 18 to reach the substrate 24 simultaneously, a film of alloy 42 substantially uniform throughout its thickness will be deposited.

In the preferred embodiment, a magnetron is used as the target assembly 19. In the cross sectional view of FIGURE 1, two points 45 and 46 represent the localized target sites from which atoms 32 are emitted. When a magnetron is not used, however, a uniform emission of atoms occurs over the surface of each target 16 and 18. A magnetron allows proper operation at lower pressure in the chamber 10 which results in a greater mean free path for the atoms 32 that eventually bombard the substrate 24. The target atoms in a sputtering system obey the so-called cosine law as mentioned hereinabove, according to which most of the atoms 32 are emitted perpendicular to the plane of the target 16. That principle, in combination with low pressure, results in a focusing of the atoms 32 onto the substrate 24. Thus, if two or more targets 16 and 18 are oriented to allow for focusing on a small area of substrate 24, the result is a uniform thin film 42 that consists of the same percentage of first target material 16 and second target material 18 throughout the thickness of the thin film. That is to say, the thin film 42 will be homogeneous and uniform throughout its depth. The composition of the resulting alloy is directly dependent on the rate of arrival of atoms from the first target 16 versus the rate of arrival of atoms from the second target 18. That is, the proportionally greater the number of atoms from one target that impinge on the substrate 24, the correspondingly higher percentage of that target's material will be present in the resulting alloy 42. The rate of atom deposition from each of the targets 16 and 18 is dependent upon the respective power supplied by power sources 20 and 22 connected thereto, the natural sputtering characteristics of the material, and finally the relative distance between the substrate 24 and each target.

By adjusting the shields 28 and 30 and moving the substrate 24 relative to the target assemblies 19 and 19a by means of the movable carrier 26, a film 42 of substantially pure material from one of the targets 16 or 18 can be deposited directly on the substrate 24 initially. Such a film 42 may possess favorable adhesion characteristics, for example. Subsequent shield 28 and 30 and substrate 24 maneuvering relative to the target assemblies 19 and 19a can then result in another layer of alloy or mixture being deposited on the first pure layer 42. The second layer, not separately shown in FIGURE 1, may have desirable characteristics (e.g., electrical conductance) that do not necessarily include adhesiveness. Similarly, an operator may wish to deposit a first layer of film 42 comprising an alloy or mixture of the target materials 16 and 18 directly on the substrate 24 and to deposit a subsequent layer of substantially pure material from one of the targets 16 or 18 onto the first mixture layer 42. Variations of such procedures, including the deposition or three or more layers using two or more target materials and/or allowing the transitions between layers to be gradual or abrupt, resulting in integrated or discrete layers respectively, are considered to be within the scope of the present invention.

## Claims

1. An apparatus for creating a vacuum deposited alloy on a substrate comprising:
   a) a sputtering chamber having a gas therein and being capable of sustaining a relatively high vacuum;
   b) at least two target electrodes disposed in said chamber, the first of said target electrodes comprising a first material and the second of said target electrodes comprising a second material different than said first material;
   c) a shield perpendicular to said substrate and dividing the area surrounding one target electrode from the area surrounding the at least one other target electrode to prevent material from said electrodes from interacting with each other;
   d) means for supplying electrical power to said electrodes to initiate sputtering activity thereof; and
   e) said substrate being oppositely disposed to said targets with said targets being oriented with respect to said substrate in such a way that atoms emitted perpendicular to the plane of said targets is - in combination with low pressure - focused onto said substrate.

2. The apparatus in accordance with claim 1 wherein the target forming material consists of an electrical insulator or conductor, e.g. a material of the group chromium, copper, palladium, nickel, ceramic, gold, silver, semiconductor material, such as doped silicon dioxide or gallium arsenide, or an alloy being composed of two or more elements.

3. The apparatus in accordance with claim 1 or 2 wherein each of said electrodes consists essentially of one material.

4. The apparatus in accordance with any one of claims 1 to 3 further comprising shielding means disposed between said target electrodes and said substrate.

5. The apparatus in accordance with any one of claims 1 to 4 further comprising a variable power control operatively connected to the target electrodes for providing power thereto, supplying alternating, like radio frequency, or direct voltage and optionally the power controls for the two targets being operated independently with respect to one another.

6. The apparatus in accordance with any one of claims 1 to 5 further comprising an additional target electrode, said additional target electrode comprising a material different than that of either of said two target electrodes, to form a resultant alloy comprising three materials.

7. The apparatus in accordance with any one of claims 1 to 6 wherein said substrate is adapted to move relative to each of said target electrodes.

8. Apparatus for manufacturing a vacuum deposited composition comprising:
   a ) a vacuum chamber;
   b) a platform disposed in said vacuum chamber for receiving a thin film;
   c) two target electrodes disposed in said vacuum chamber in spaced apart relationship with respect to one another and oriented with respect to said platform in such a way that atoms emitted perpendicular to the plane of said targets are - in combination with low pressure - focused onto said platform, the first of said target electrodes comprising a first material and the second of said target electrodes comprising a second material;

d) a shield perpendicular to said platform and dividing the area surrounding said first target electrode from the area surrounding said second target electrode to prevent material from said electrodes from interacting with each other; and

e) means for introducing a reactive gas into said chamber so that when electrical power is applied to said target electrodes, a substantially homogeneous thin film composition comprising said first and second materials and said reactive gas can be formed on said platform.

9. The apparatus in accordance with claim 8 wherein one of said target material comprises a metal and said reactive gas comprises oxygen.

10. The apparatus in accordance with claim 8 or 9 further comprising:

e) a first power supply operatively connected to said first target electrode for initiating sputtering thereof; and

f) a second power supply operatively connected to said second target electrode for initiating sputtering thereof.

11. Apparatus for producing a composition having two major components comprising:

a) a vacuum chamber;

b) a substrate having an upper surface disposed in said vacuum chamber;

c) a shield perpendicular to said substrate and forming an area to prevent the interaction of said two major components; and

d) a target assembly disposed in said vacuum chamber opposite said substrate, said target assembly comprising two discrete portions, one of said portions being formed of a first substantially pure molecular component and the other of said portions being formed of a second substantially pure molecular component, both of said portions being oriented with respect to said upper surface in such a way that atoms emitted perpendicular to the plane of said portions are - in combination with low pressure - focused onto said upper surface, for sputter depositing simultaneously thereon a composition comprising said first and second molecular components when power is applied to both of said portions of said target assembly with sufficient intensity to cause sputtering thereof.

12. Application of an apparatus in accordance with any one of the preceding claims for creating a vacuum deposited alloy or composition by sputtering where the rate with which the atoms are emitted from the targets is controlled separately for each target, optionally in such a way that the composition of the deposited material varies in a predetermined way as a function of the relative distance of each target from the substrate surface.

**Patentansprüche**

1. Anordnung zum Erzeugen einer im Vakuum abgeschiedenen Legierung auf einem Substrat, folgendes enthaltend:

a) eine Zerstäubungskammer, welche ein Gas enthält und ein relativ hohes Vakuum aufrechterhalten kann;

b) mindestens zwei Auftreffelektroden in der Kammer, wobei die erste ein erstes und die zweite ein zweites Material enthält, welches sich vom ersten unterscheidet;

c) eine Abschirmung senkrecht zum Substrat, die den Bereich um eine Auftreffelektrode vom Bereich um die mindestens eine andere Auftreffelektrode trennt, um zu verhindern, daß Materialien von den Elektroden miteinander in Wechselwirkung treten;

d) Mittel zum Beaufschlagen der Elektroden mit Strom, um den Zerstäubungsvorgang einzuleiten; und

e) Anbringen des Substrats gegenüber den Auftreffelektroden, wobei diese zu diesem Substrat so ausgerichtet sind, daß senkrecht zur Ebene der Auftreffelektroden emittierte Atome - in Kombination mit niedrigem Druck - auf das Substrat fokussiert sind.

2. Anordnung nach Anspruch 1, bei welcher das die Auftreffelektroden bildende Material aus einem elektrischen Isolator oder Leiter besteht, z.B. aus einem Material aus der Gruppe Chrom, Kupfer, Palladium, Nickel, Keramik, Gold, Silber, Halbleitermaterial, wie dotiertes Siliziumdioxid oder Galliumarsenid, oder einer aus zwei oder mehr dieser Elemente bestehenden Legierung.

3. Anordnung nach Anspruch 1 oder 2, bei welcher jede der Elektroden im wesentlichen aus einem Material besteht.

4. Anordnung nach einem der Ansprüche 1 bis 3, welche weiterhin Abschirmmittel zwischen den Auftreffelektroden und dem Substrat enthält.

5. Anordnung nach einem der Ansprüche 1 bis 4, mit variabler Energieversorgung, die operativ mit den Auftreffelektroden verbunden ist, um sie mit Energie zu beaufschlagen, wobei Wechselspannung, wie Hochfrequenz, oder Gleichspannung, und wobei gegebenenfalls die Energieversorgungen für die zwei Auftreffplatten unabhängig voneinander betrieben werden können.

6. Anordnung nach einem der Ansprüche 1 bis 5, welche weiterhin eine zusätzliche Auftreffelektrode mit einem Material enthält, das sich von dem der beiden genannten Auftreffelektroden unterscheidet, sodaß eine Legierung mit drei Materialien entsteht.

7. Anordnung nach einem der Ansprüche 1 bis 6, bei welcher das Substrat relativ zu jeder der Auftreffelektroden bewegt werden kann.

8. Anordnung zum Herstellen einer im Vakuum abgeschiedenen Zusammensetzung, folgendes enthaltend:

a) eine Vakuumkammer;

b) eine Plattform in der Vakuumkammer zur Aufnahme eines dünnen Films;

c) zwei Auftreffelektroden in der Vakuumkammer beabstandet voneinander und bezüglich der Plattform so ausgerichtet, daß senkrecht zur Ebene der Auftreffelektroden emittierte Atome in Kombination mit niedrigem Druck auf die Plattform gerichtet werden, wobei die erste der Auftreffelektroden ein erstes Material und die zweite ein zweites Material enthält;

d) eine Abschirmung senkrecht zur Plattform, welche den Bereich um die erste Auftreffelektrode von dem um die zweite trennt, um zu verhindern, daß Materialien von den Elektroden miteinander in Wechselwirkung treten; und

e) Mittel zum Einführen eines Reaktivgases in die Kammer, so daß beim Beaufschlagen der Auftreffelektroden mit Strom ein im wesentlichen homogenes Dünnschichtmaterial, welches das erste und das zweite Material und das Reaktivgas enthält, auf der Plattform gebildet werden kann.

9. Anordnung nach Anspruch 8, bei welcher eines der Auftreffmaterialien ein Metall und das Reaktivgas Sauerstoff enthält.

10. Anordnung nach Anspruch 8 oder 9, weiterhin folgendes enthaltend:

e) eine erste Energieversorgung, welche operativ mit der ersten Auftreffelektrode verbunden ist, um den Zerstäubungsprozess für dieselbe einzuleiten; und

f) eine zweite Energieversorgung, welche operativ mit der zweiten Auftreffelektrode verbunden ist, um den Zerstäubungsprozeß für dieselbe einzuleiten.

11. Anordnung zum Erzeugen einer Zusammensetzung mit zwei Hauptbestandteilen, folgendes enthaltend:

a) eine Vakuumkammer;

b) ein Substrat, von welchem sich eine Oberfläche in der Vakuumkammer befindet;

c) eine Abschirmung senkrecht zum Substrat, welche einen Bereich bildet, in dem eine Wechselwirkung zwischen den zwei Hauptbestandteilen ausgeschlossen ist; und

d) eine Auftreffanordnung in der Vakuumkammer gegenüber dem Substrat, wobei die Auftreffanordnung zwei getrennte Teile enthält, von denen einer aus einem ersten im wesentlichen reinen molekularen Bestandteil und der andere aus einem zweiten im wesentlichen reinen molekularen Bestandteil besteht und beide zu der Oberfläche des Substrats so ausgerichtet sind, daß senkrecht zur Ebene der Teile emittierte Atome in Kombination mit niedrigem Druck auf die Oberfläche gerichtet werden, um, wenn beide Teile der Auftreffanordnung mit einem Strom beaufschlagt werden, der zum Einleiten des Zerstäubungsvorganges ausreicht, gleichzeitig eine Zusammensetzung darauf durch Zerstäuben zu erzeugen, welche die ersten und zweiten Molekularbestandteile enthält.

12. Anwendung einer Anordnung nach einem der vorhergehenden Ansprüche zum Herstellen einer im Vakuum abgeschiedenen Legierung oder Zusammensetzung durch Zerstäuben, wobei die Geschwindigkeit, mit welcher die Atome von den Auftreffelementen emittiert werden, für jedes Auftreffelement getrennt gesteuert wird, und zwar gegebenenfalls so, daß die Zusammensetzung des abgeschiedenen Materials in einer bestimmten Weise abhängig von der relativen Entfernung jeder Auftreffplatte von der Substratoberfläche variiert.

**Revendications**

1. Appareil pour réaliser un alliage déposé sous vide sur un substrat, comprenant:

a) une chambre de pulvérisation comprenant un gaz et capable de supporter un vide relativement important;

b) au moins deux électrodes de cibles disposées dans la chambre, la première des électrodes de cibles comprenant un premier matériau et la deuxième des électrodes de cibles comprenant un deuxième matériau différent du premier matériau;

c) un écran, perpendiculaire au substrat, séparant la zone entourant une électrode de cible de la zone entourant la au moins une autre électrode de cible pour empêcher les matériaux des électrodes d'interagir l'un avec l'autre;

d) des moyens pour fournir une alimentation électrique aux électrodes pour commencer une activité de pulvérisation: et

e) le substrat étant disposé en face des cibles, les cibles étant orientées par rapport au substrat de façon à ce que les atomes émis de manière perpendiculaire au plan des cibles sont - en combinaison avec une basse pression - focalisés sur le substrat.

2. Appareil selon la revendication 1, dans lequel le matériau formant les cibles est constitué d'un isolant ou d'un conducteur électrique, par exemple un matériau du groupe comprenant le chrome, le cuivre, le palladium, le nickel, la céramique, l'or, l'argent, d'un matériau semiconducteur comme du dioxyde de silicium dopé ou de l'arséniure de gallium, ou d'un alliage composé de deux éléments ou plus.

3. Appareil selon l'une des revendications 1 ou 2, dans lequel chacune des électrodes est constituée essentiellement d'un matériau.

4. Appareil selon l'une quelconque des revendications 1 à 3, comprenant en outre des moyens formant écran disposés entre les électrodes de cibles et le substrat.

5. Appareil selon l'une quelconque des revendications 1 à 4 comprenant en outre une commande de puissance variable connectée en fonctionnement aux électrodes de cibles pour les alimenter en puissance délivrant du courant alternatif comme du courant de fréquence élevée, ou du courant continu, les commandes de puissance des deux cibles pouvant être indépendamment actionnées l'une par rapport à l'autre.

6. Appareil selon l'une quelconque des revendications 1 à 5 comprenant en outre une électrode de cible supplémentaire, l'électrode de cible supplémentaire comprenant un matériau différent de celui de chacune des deux électrodes de cibles pour former un alliage résultant comprenant trois matériaux.

7. Appareil selon l'une quelconque des revendications 1 à 6, dans lequel le substrat est adapté à se déplacer par rapport à chacune des électrodes de cibles.

8. Appareil de fabrication d'une composition déposée sous vide, comprenant:

a) une chambre à vide;

b) une plate-forme disposée dans la chambre à vide pour recevoir une couche mince;

c) deux électrodes de cibles disposées dans la chambre à vide de manière espacée l'une de l'autre et orientées par rapport à la plate-forme de telle façon que des atomes émis de manière perpendiculaire au plan des cibles sont – en combinaison avec une basse pression – focalisés sur la plate-forme, la première des électrodes de cibles comprenant un premier matériau et la deuxième des électrodes de cibles comprenant un deuxième matériau;

d) un écran perpendiculaire à la plate-forme et séparant la zone entourant la première électrode de cible de la zone entourant la deuxième électrode de cible pour empêcher les matériaux des électrodes d'interagir l'un avec l'autre; et

e) des moyens pour introduire un gaz réactif dans la chambre de sorte que, quand une alimentation électrique est appliquée aux électrodes de cibles, une composition de couche mince sensiblement homogène comprenant les premier et second matériaux et le gaz réactif peut être formée sur la plate-forme.

9. Appareil selon la revendication 8, dans lequel l'un des matériaux de cible est constitué d'un métal, et le gaz réactif est constitué d'oxygène.

10. Appareil selon l'une des revendications 8 ou 9, comprenant en outre:

e) une première source d'alimentation connectée opérativement à la première électrode de cible pour commencer sa pulvérisation; et

f) une deuxième source d'alimentation connectée opérativement à la deuxième électrode de cible pour commencer sa pulvérisation.

11. Appareil pour produire une composition de deux composants pricipaux, comprenant:

a) une chambre à vide;

b) un substrat ayant une surface supérieure disposée dans la chambre à vide;

c) un écran, perpendiculaire au substrat, formant une séparation pour empêcher l'interaction entre les deux composants principaux; et

d) un montage de cible disposé dans la chambre à vide de façon opposée par rapport au substrat, le montage de cible comprenant deux parties distinctes, l'une des parties étant formée d'un premier composant moléculaire sensiblement pur et l'autre partie étant formée d'un deuxième composant moléculaire sensiblement pur, les deux parties étant orientées, par rapport à la surface supérieure, de façon à ce que les atomes émis de manière perpendiculaire aux plans des parties sont – en combinaison avec une basse pression – focalisés sur la surface supérieure pour déposer sur elle par pulvérisation, simultanément une composition comprenant les premier et deuxième composants moléculaires quand une alimentation est appliquée aux deux parties du montage de cible avec une intensité suffisante pour entraîner leurs pulvérisations.

12. Application d'un appareil selon l'une quelconque des revendications précédentes pour réaliser un alliage ou une composition déposés sous vide par pulvérisation, où le taux selon lequel les atomes sont émis à partir des cibles est commandé séparément pour chaque cible, de manière optionnelle, de telle sorte que la composition du matériau déposé varie d'une manière prédéterminée en fonction de la distance relative entre chaque cible et la surface du substrat.

# FIG. 1

EP 0 230 652 B1